# EUROPÄISCHE PATENTANMELDUNG

(11) **EP 2 506 276 A1**
(43) Veröffentlichungstag der Anmeldung: **03.10.2012**
(21) Anmeldenummer: 11160619.0
(22) Anmeldetag: 31.03.2011
(51) Int. Cl.: H01G 9/20

(54) **Farbstoffsensibilisierte Solarzelle mit stickstoffdotierten Kohlenstoffnanoröhren**

(71) Anmelder: Bayer MaterialScience AG, 51368 Leverkusen (DE)
(72) Erfinder: Figgemeier, Egbert, 42799 Leichlingen (DE)

(57) **Zusammenfassung**

Eine farbstoffsensibilisierte Solarzelle umfasst eine Metalloxidelektrode, eine Gegenelektrode, welche der Metalloxidelektrode zugewandt ist und einen zwischen der Metalloxidelektrode und der Gegenelektrode angeordneten Elektrolyten, wobei die Metalloxidelektrode einen hierauf befindlichen Farbstoff umfasst und der Elektrolyt ein elektrochemisches Redoxpaar umfasst. Weiterhin sind zwischen der Metalloxidelektrode und der Gegenelektrode stickstoffdotierte Kohlenstoffnanoröhren (N-CNT) angeordnet, welche mit der Gegenelektrode elektrisch kontaktiert sind. Die Erfindung betrifft weiterhin ein Verfahren zur Gewinnung von elektrischer Energie mittels erfindungsgemäßer farbstoffsensibilisierter Solarzellen und die Verwendung von stickstoffdotierten Kohlenstoffnanoröhren als Katalysator in der Reaktion eines elektrochemischen Redoxpaares, insbesondere des Redoxpaares I⁻/I₃⁻.

## Beschreibung

Die vorliegende Erfindung betrifft eine farbstoffsensibilisierte Solarzelle, umfassend eine Metalloxidelektrode, eine Gegenelektrode, welche der Metalloxidelektrode zugewandt ist und einen zwischen der Metalloxidelektrode und der Gegenelektrode angeordneten Elektrolyten, wobei die Metalloxidelektrode einen hierauf befindlichen Farbstoff umfasst und der Elektrolyt ein elektrochemisches Redoxpaar umfasst. Die Erfindung betrifft weiterhin ein Verfahren zur Gewinnung von elektrischer Energie mittels erfindungsgemäßer farbstoffsensibilisierter Solarzellen und die Verwendung von stickstoffdotierten Kohlenstoffnanoröhren als Katalysator in der Reaktion eines elektrochemischen Redoxpaares.

Eine farbstoffsensibilisierte Solarzelle oder Grätzel-Zelle ("dye-sensitized solar cell" oder "dye-sensitized nanocrystalline solar cell") ist im Wesentlichen aus zwei Elektroden aufgebaut, zwischen welchen ein photoelektrochemischer Prozess zur Gewinnung von Elektrizität abläuft. Ein wichtiger Bestandteil dieser Solarzelle ist die Gegenelektrode, an welcher ein Redoxpaar (I⁻/I₃⁻) zur Erhaltung des Prozesses reduziert wird. Darüber hinaus sollte diese Gegenelektrode einen effizienten Katalysator für diese Redoxreaktion beinhalten. Üblicherweise ist dieser ein edelmetall-basierte Katalysator wie zum Beispiel ein metallischer Platin-Katalysator. Der Einsatz von Edelmetallen ist jedoch immer mit hohen Kosten verbunden, so dass Alternativen hierzu gewünscht sind.

EP 2 061 049 A2 erwähnt in einer Ausführungsform der dort beschriebenen farbstoffsensibilisierten Solarzelle, dass deren zweite Elektrode ein leitfähiges Substrat umfasst, welches mit einer Platinschicht und/oder mit einer Schicht aus Kohlenstoffnanoröhren beschichtet ist. Die farbstoffsensibilisierte Solarzelle selbst umfasst eine erste Elektrode und eine der ersten Elektrode zugewandte zweite Elektrode mit einer zwischen der ersten und der zweiten Elektrode befindlichen Elektrolytschicht. Die erste Elektrode beinhaltet eine transparente und poröse leitende Schicht und eine Schicht von Halbleiteroxid-Nanopartikeln in den Poren der transparenten porösen leitenden Schicht, welche der zweiten Elektrode zugewandt ist. Farbstoffmoleküle sind in die Nanopartikel-Halbleiteroxidschicht adsorbiert.

Hinweise auf die Funktion oder Vorteile der Schicht aus Kohlenstoffnanoröhren werden in EP 2 061 049 A2 jedoch nicht gegeben.

EP 2 256 764 A2 offenbart eine farbstoffsensibilisierte Solarzelle mit einem Elektrolyten frei von organischen Lösungsmitteln, welche zu sehr effizienter photoelektrischer Umwandlung in der Lage ist. Weiterhin offenbart diese Patentanmeldung einen neuen und praktischen Elektrolyten frei von organischen Lösungsmitteln für eine solche farbstoffsensibilisierte Solarzelle. Ein Elektrolyt, der frei von organischen Lösungsmitteln ist, enthält ein leitfähiges Kohlenstoffmaterial, Wasser und eine anorganische Iodverbindung. Dieser Elektrolyt ist vorzugsweise ein quasi-fester Elektrolyt und das leitfähige Kohlenstoffmaterial im Elektrolyten weist vorzugsweise eine Oberfläche von 30 bis 300 m²/g auf. Gemäß dieser Patentanmeldung kann dann auf die Verwendung von Platin bei der Gegenelektrode verzichtet werden. In den Beispielen dieser Patentanmeldung wird eine Handelsform von Leitruß als Kohlenstoffmaterial eingesetzt. Der höchste angegebene photochemische Wirkungsgrad ist 1,82%.

Angesichts dieser Nachteile im Stand der Technik hat sich die vorliegende Erfindung die Aufgabe gestellt, eine Möglichkeit zur Verringerung oder Vermeidung des Einsatzes von teuren Edelmetallkatalysatoren in farbstoffsensibilisierten Solarzellen bereitzustellen, welche einen höheren Wirkungsgrad als bislang beschrieben aufweist.

Diese Aufgabe wird erfindungsgemäß gelöst durch eine farbstoffsensibilisierte Solarzelle, umfassend:
- eine Metalloxidelektrode;
- eine Gegenelektrode, welche der Metalloxidelektrode zugewandt ist; und
- einen zwischen der Metalloxidelektrode und der Gegenelektrode angeordneten Elektrolyten;
wobei die Metalloxidelektrode einen hierauf befindlichen Farbstoff umfasst und der Elektrolyt ein elektrochemisches Redoxpaar umfasst und wobei zwischen der Metalloxidelektrode und der Gegenelektrode stickstoffdotierte Kohlenstoffnanoröhren angeordnet sind, welche mit der Gegenelektrode elektrisch kontaktiert sind.

Es wurde festgestellt, dass stickstoffdotierte Kohlenstoffnanoröhren die Reaktion des in der Solarzelle befindlichen elektrochemischen Redoxpaares, insbesondere des Redoxpaares Iodid/Triiodid katalysieren können und damit eine hohe Effizienz auch ohne ein Edelmetall als Katalysator erreicht werden kann.

Stickstoffdotierte Kohlenstoffnanoröhren (N-CNTs) sind im Rahmen der vorliegenden Erfindung Stickstoffatome umfassende Kohlenstoffnanoröhren (CNTs) und hierbei insbesondere solche, in deren Graphenlagen zusätzliche Stickstoffatome eingebaut sind. Weiterhin ist es beispielsweise möglich, dass stickstoffdotierte CNTs primäre, sekundäre, tertiäre und/oder quaternäre Aminogruppen aufweisen, welche direkt oder über weitere Molekülfragmente ("Spacer") an die CNTs gebunden sind. Die Bindungszustände lassen sich mittels Röntgen-Photoelektronenspektroskopie für die N1 s-Linie erkennen. So erhält man bei einer Anregung mit monochromatischer A1 K_{α}-Strahlung (1486,6 eV) Bindungsenergien zwischen 398 und 405 eV: beispielsweise für pyridinisch gebundenen Stickstoff eine Bindungsenergie von 398,7 +/- 0,2 eV, für pyrrolisch gebundenen Stickstoff eine Bindungsenergie von 400,7 eV, für quaternär gebundenen Stickstoff eine Bindungsenergie von 401,9 eV. Die oxidierten Stickstoffgruppen sind in der N 1 s-Linie bei 403 bis 405 eV sichtbar.

Die stickstoffdotierten CNTs können in agglomerierter Form, in teilweise agglomerierter Form oder in desagglomerierter Form vorliegen.

Es sind einige Verfahren zur Herstellung von N-CNTs bekannt. Geeignete Kohlenstoffnanoröhren als Ausgangsmaterial sind insbesondere alle einwandigen oder mehrwandigen Kohlenstoffnanoröhren vom Zylinder-Typ (zum Beispiel gemäß US 5,747,161 und WO 86/03455 A1), Scroll-Typ, Multiscroll-Typ, Cup-stacked-Typ aus einseitig geschlossenen oder beidseitig offenen, konischen Bechern bestehend (zum Beispiel gemäß EP 0 198 558 A2 und US 7,018,601), oder mit zwiebelartiger Struktur. Bevorzugt sind mehrwandige Kohlenstoffnanoröhren vom Zylinder-Typ, Scroll-Typ, Multiscroll-Typ und Cup-stacked-Typ oder deren Mischungen einzusetzen. Günstig ist es, wenn die Kohlenstoffnanoröhren ein Verhältnis von Länge zu Außendurchmesser von ≥ 5, bevorzugt ≥100 haben. Besonders bevorzugt sind als Kohlenstoffnanoröhren mehrwandige Kohlenstoffnanoröhren mit einem durchschnittlichen äußeren Durchmesser von ≥ 3 nm bis ≤ 100 nm und einem Verhältnis von Länge zu Durchmesser von ≥ 5.

WO 2010/127767 A1 offenbart ein Verfahren zur Herstellung von graphitischen Kohlenstoffmaterialien, die pyridinische, pyrrolische und/oder quaternäre Stickstoffgruppen mindestens an ihrer Oberfläche umfassen, ausgehend von Kohlenstoffnanoröhren, wobei die Kohlenstoffnanoröhren unter Stickstoffatmosphäre gemahlen werden.

DE 10 2007 062 421 A1 beschreibt ein Verfahren zur Herstellung stickstoffdotierter Kohlenstoffnanoröhrchen (NCNT), welches mindestens die Schritte umfasst:
a. Fällen von mindestens einem Metall (M) aus einer Lösung eines Metallsalzes (MS) des mindestens einen Metalls (M) in einem Lösungsmittel (L), erhaltend eine Suspension (S) umfassend einen Feststoff (F),
b. Abtrennen und gegebenenfalls Nachbehandeln des Feststoffes(F) aus der Suspension (S), erhaltend einen heterogenen Metallkatalysator (K),
c. Einleiten des heterogenen Metallkatalysators (K) in eine Wirbelschicht,
d. Reaktion mindestens eines Eduktes (E), das Kohlenstoff und Stickstoff umfasst, oder von mindestens zwei Edukten (E), wobei mindestens eines Kohlenstoff umfasst und mindestens eines Stickstoff umfasst, in der Wirbelschicht an dem heterogenen Metallkatalysator (K), erhaltend stickstoffdotierte Kohlenstoffnanoröhren (N-CNT),
e. Austrag der stickstoffdotierten Kohlenstoffnanoröhren (N-CNT) aus der Wirbelschicht.

Beispiele für geeignete Metalloxidelektroden sind Elektroden aus Titandioxid, SnO₂ und/oder InO₃. Der Farbstoff kann direkt auf der Metalloxidelektrode angebunden oder aufgetragen sein. Es ist aber auch möglich, dass zwischen der Metalloxidelektrode und dem Farbstoff sich noch eine oder mehrere geeignete Zwischenschichten befinden. Die Metalloxidelektrode kann ganz oder teilweise in Partikel-oder Nanopartikelform vorliegen. Beispiele für Substrate, auf welchen die Metalloxidelektrode angeordnet sein kann, sind Indium-Zink-Oxid (IZO), Indium-Zinn-Oxid (ITO) und/oder FTO, welches durch Dotierung von SnO₂ mit Fluor erhalten wird.

Die Gegenelektrode kann im einfachsten Fall ein elektrisch leitfähiges Material sein, auf welchem die stickstoffdotierten CNTs geträgert sind.

Der Elektrolyt kann ein wässriger oder nicht-wässriger Elektrolyt sein. Weiterhin ist es möglich, dass der Elektrolyt eine ionische Flüssigkeit umfasst.

Hinsichtlich des Farbstoffs sind zunächst keine Beschränkungen vorgesehen. So kann der Farbstoff ein Ru-basierter Metallkomplex und/oder einen organischen Farbstoff, insbesondere einen Farbstoff auswählt aus der Gruppe bestehend aus Azofarbstoffen, Oligoenen, Merocyaninen oder Mischungen von diesen sein.

Das elektrochemische Redoxpaar ist ein reversibles Redoxpaar, dessen Redoxreaktion durch die stickstoffdotierten CNTs katalysiert wird. Nach einer Lichtabsorption durch den Farbstoff wird dieser angeregt und gibt unter Bildung einer oxidierten Form Elektronen in die (halbleitende) Metalloxidelektrode ab. Nach Durchlaufen eines elektrischen Stromkreises gelangen sie zur Gegenelektrode, wo sie, katalysiert durch die stickstoffdotierten CNTs, die oxidierte Form des Redoxpaares reduzieren. Die reduzierte Form des Redoxpaares steht dann zur Verfügung, um Elektronen direkt oder indirekt an die oxidierte Form des Farbstoffs abzugeben.

Die vorliegende Erfindung wird nachfolgend im Zusammenhang mit bevorzugten Ausführungsformen weiter beschrieben. Sie können beliebig kombiniert werden, sofern sich aus dem Zusammenhang nicht eindeutig das Gegenteil ergibt.

In einer Ausführungsform der erfindungsgemäßen Solarzelle umfasst das elektrochemische Redoxpaar eine anorganische Iodverbindung. Vorzugsweise ist das elektrochemische Redoxpaar das Redoxpaar I⁻/I₃⁻. Solche Redoxpaare lassen sich beispielsweise durch die Zugabe von Iodid, elementarem Iod, Iodat und/oder Periodat zum Elektrolyten erhalten.

In einer weiteren Ausführungsform der erfindungsgemäßen Solarzelle ist die Gegenelektrode frei von Metallen aus der Gruppe Cobalt, Rhodium, Iridium, Nickel, Palladium, Platin, Kupfer, Silber und Gold. Der Begriff "frei von" beinhaltet im Rahmen der vorliegenden Erfindung die Anwesenheit von technisch unvermeidlichen Spuren der genannten Metalle, welche unter Umständen durch der Herstellung der CNTs mit eingeschleppt wurden. Auf jeden Fall beinhaltet die Gegenelektrode in dieser Ausführungsform keine makroskopischen Flächen dieser Metalle in elementarer Form, wie sie im Stand der Technik als zum Beispiel Platinelektroden anzutreffen sind.

In einer weiteren Ausführungsform der erfindungsgemäßen Solarzelle sind die stickstoffdotierten Kohlenstoffnanoröhren mit der Gegenelektrode verbunden. Die Verbindung kann beispielsweise mechanisch oder mittels eines Bindemittels erfolgen. Vorzugsweise sind die stickstoffdotierten CNTs dann nicht mehr frei im Elektrolyten zwischen den beiden Elektroden angeordnet, sondern befinden sich nur noch an und im elektrischen Kontakt mit der Gegenelektrode.

In einer weiteren Ausführungsform der erfindungsgemäßen Solarzelle weisen die stickstoffdotierten Kohlenstoffnanoröhren einen Stickstoffgehalt von ≥ 0,1 Atom-% bis ≤ 10 Atom-% auf. Der Atomgehalt lässt sich mittels Röntgen-Photoelektronenspektroskopie durch Integration der Signale für die N1s-Linie erkennen. Eine geeignete Anregung ist mit monochromatischer A1 K_{α}-Strahlung (1486,6 eV). Bevorzugte Bereiche für den Stickstoffgehalt sind ≥ 1 Atom-% bis ≤ 8 Atom-% und > 3 Atom-% bis ≤ 7 Atom-%. Weiterhin ist es bevorzugt, wenn ≥ 50% bis ≤ 100% der Stickstoffatome in pyridinischer und/oder pyrrolischer Form vorliegen.

In einer weiteren Ausführungsform der erfindungsgemäßen Solarzelle umfassen die stickstoffdotierten Kohlenstoffnanoröhren pyridinische, pyrrolische und/oder quaternäre Stickstoffgruppen mindestens an ihrer Oberfläche. Wie bereits erwähnt lassen sich diese Gruppen durch ihre charakteristischen Signale für die N1s-Linie im Röntgen-Photoelektronenspektrum bei einer Anregung mit monochromatischer A1 K_{α}-Strahlung (1486,6 eV) durch Bindungsenergien zwischen 398 und 405 eV erkennen.

In einer weiteren Ausführungsform der erfindungsgemäßen Solarzelle sind die stickstoffdotierten Kohlenstoffnanoröhren durch ein Verfahren erhältlich, welches die folgenden Schritte umfasst:
- Fällen zweier Metallsalze (MS) der Metalle (M) Cobalt und Mangan, zusammen mit weiteren Komponenten (I) umfassend Magnesium und Aluminium in einem Lösungsmittel (L) unter Erhalt einer Suspension (S) umfassend einen Feststoff (F);
- Abtrennen und gegebenenfalls Nachbehandeln des Feststoffs (F) aus der Suspension (S) unter Erhalt eines heterogenen Metallkatalysators (K) der Form M¹:M²:I¹O:I²O, in dem
   M¹ Mangan ist und in einem Massenanteil von ≥ 2% bis ≤ 65% vorliegt,
   M² Cobalt ist und in einem Massenanteil von ≥ 2% bis ≤ 80% vorliegt,
   I¹O Al₂O₃ ist und in einem Massenanteil von ≥ 5% bis ≤ 76% vorliegt und
   I²O MgO ist und in einem Massenanteil von ≥ 5% bis ≤ 70% vorliegt,
   wobei sich die genannten Massenanteile zu ≤ 100% addieren;
- Einleiten des heterogenen Metallkatalysators (K) in eine Wirbelschicht;
- Reaktion mindestens eines gasförmigen Eduktes (E), das eine stickstoffhaltige organische Verbindung umfasst, in der Wirbelschicht an dem heterogenen Metallkatalysator (K) bei Temperaturen zwischen 300 °C und 1600 °C unter Erhalt von stickstoffdotierten Kohlenstoffnanoröhren;
- Austragen der stickstoffdotierten Kohlenstoffnanoröhren aus der Wirbelschicht.

Vorzugsweise ist das Edukt (E), ausgewählt aus der Liste Acetonitril, Dimethylformamid, Acrylnitril, Propionsäurenitril, Buttersäurenitril, Pyridin, Pyrrol, Pyrazol, Pyrrolidin und/oder Piperidin.

Es ist weiterhin möglich, neben dem mindestens einen Edukt (E) ein weiteres Edukt zu verwenden, das keinen Stickstoff umfasst. Bevorzugt ist dieses weitere Edukt ausgewählt ist aus der Liste Methan, Ethan, Propan, Butan, oder/oder höhere Aliphaten, die unter den Bedingungen in der Reaktionszone gasförmig vorliegen, sowie Ethylen, Propylen, Buten, Butadien und/oder höhere Olefine, die unter den Bedingungen in der Reaktionszone gasförmig vorliegen, Acetylen, oder aromatische Kohlenwasserstoffe, die unter den Bedingungen in der Reaktionszone gasförmig vorliegen. Weitere Gase umfassen bevorzugt Wasserstoff und/oder Inertgase. Inertgase umfassen bevorzugt Edelgase oder Stickstoff.

Die Zusammensetzung des Gemisches der in die Reaktionszone eingeleiteten Gase besteht üblicherweise aus 0-90 Vol.-% Wasserstoff, 0-90 Vol.-% eines Inertgases wie z. B. Stickstoff oder Argon und 5-100 Vol.-% des mindestens (E) in gasförmigem Aggregatzustand, bevorzugt 0-50 Vol.-% Wasserstoff, 0-80 Vol.-% eines Inertgases wie z. B. Stickstoff oder Argon und 10-100 Vol.-% des Eduktes (E) in gasförmigem Aggregatzustand, besonders bevorzugt 0-40 Vol.-% Wasserstoff, 0-50 Vol.-% eines Inertgases wie z. B. Stickstoff oder Argon und 20-100 Vol.-% des Eduktes (E) in gasförmigem Aggregatzustand.

In einer weiteren Ausführungsform der erfindungsgemäßen Solarzelle sind die stickstoffdotierten Kohlenstoffnanoröhren durch ein Verfahren erhältlich, welches das Mahlen von Kohlenstoffnanoröhren unter Ammoniak-, Amin- und/oder Stickstoffatmosphäre umfasst. Als Amine kommen grundsätzlich primäre, sekundäre und tertiäre Amine in Betracht. Eine bevorzugte Variante hierbei beinhaltet das Mahlen der CNTs unter einer unter Stickstoffatmosphäre mit einem Anteil an Stickstoff von mindestens 90 Vol.-% in einer Planetenmühle für einen Zeitraum von vier bis acht Stunden unter Eintrag einer Energie von 500 kJ pro Gramm CNTs bis 2500 kJ pro Gramm CNTs.

In einer weiteren Ausführungsform der erfindungsgemäßen Solarzelle ist der Farbstoff ausgewählt aus der Gruppe umfassend Xanthenfarbstoffe wie Eosin-Y, Cumarinfarbstoffe, Triphenylmethanfarbstoffe, Cyananinfarbstoffe, Merocyaninfarbstoffe, Phthalocyaninfarbstoffe, Naphthalocyaninfarbstoffe, Porphyrinfarbstoffe, Polypyridin-Metallkomplexfarbstoffe, Ruthenium-Bipyridinfarbstoffe, Azofarbstoffe, Chinonfarbstoffe, Chinoniminfarbstoffe, Chinacridonfarbstoffe, Squariumfarbstoffe, Perylenfarbstoffe, Indigofarbstoffe, Polymethinfarbstoffe und/oder Riboflavinfarbstoffe.

Ein weiterer Gegenstand der vorliegenden Erfindung ist ein Verfahren zur Gewinnung von elektrischer Energie mittels farbstoffsensibilisierter Solarzellen, wobei die Solarzelle eine erfindungsgemäße Solarzelle ist.

Die vorliegende Erfindung betrifft weiterhin die Verwendung von stickstoffdotierten Kohlenstoffnanoröhren als Katalysator in der Reaktion eines elektrochemischen Redoxpaares, wobei das elektrochemische Redoxpaar eine anorganische Iodverbindung umfasst. Insbesondere ist das elektrochemische Redoxpaar das Redoxpaar I⁻/I₃⁻.

Ohne hierauf beschränkt zu sein, wird die Erfindung anhand des nachfolgenden Beispiels weiter erläutert.

### Beispiel: Beeinflussung des Redoxpotentials des Redoxpaares I⁻/I₃⁻

Das Reduktionspotential des Redoxpaares I⁻/I₃⁻ ist ein entscheidender Einflussfaktor für die Effizienz der farbstoffsensibilisierten Solarzelle. Je positiver das Reduktionspotential ist, desto höher ist die Effizienz der Solarzelle, da die Potentialdifferenz zwischen der Gegenelektrode und dem Fermi-Niveau des Halbleiters über die Leerlaufspannung (V_{OC} ― open circuit voltage) entscheidet.

Die Reduktion I⁻/I₃⁻ ist ein komplexer chemischer Prozess, welcher den Einsatz von Katalysatoren für eine wirksame Solarzelle notwendig macht. Um das Potential von N-CNTs als Katalysator einschätzen zu können, wurden vergleichend die Reduktionspotentiale von I⁻/I₃⁻ in Acetonitril durch Voltammetrie mit verschiedenen Elektroden bestimmt.

Die benutzten N-CNTs wurden durch Elektronenspektroskopie (ESCA) charakterisiert und enthielten 6,5 Atom-% Stickstoff. Von diesen 6,5 Atom-% Stickstoff lagen 75% in pyridinischer beziehungsweise pyrolischer Form und 25% in nicht-aromatischer Form vor.

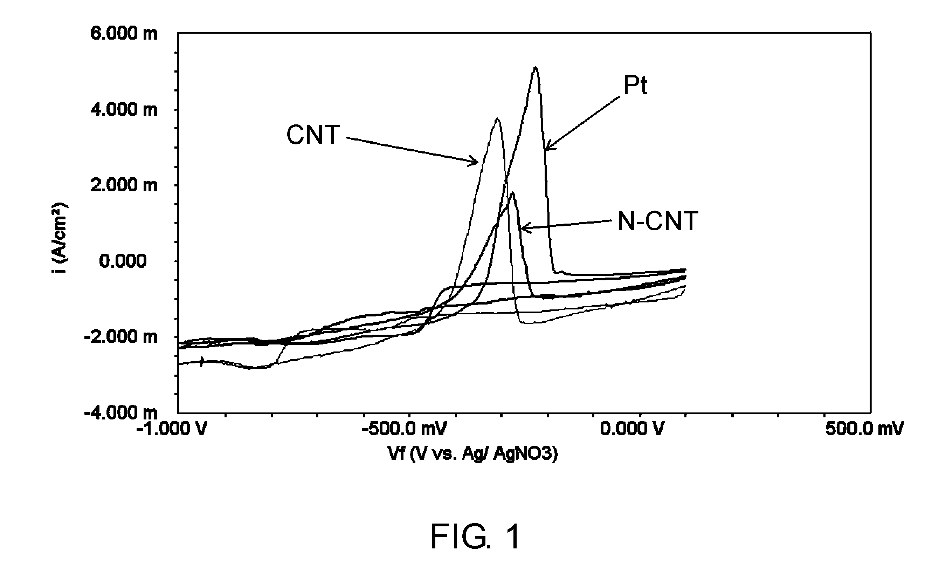

Die Ergebnisse sind in FIG. 1 dargestellt. Beim Vergleich der verschiedenen Elektrodenmaterialien zeigt sich eine sehr deutliche Abhängigkeit des Reduktionspotentials. Dabei ist zu beobachten, dass das Reduktionspotential bei der Verwendung von N-CNTs (-277 mV vs. Ag/AgNO₃) erfindungsgemäß deutlich weniger negativ ist als bei CNT-basierten Elektroden (-309 mV vs. Ag/AgNO₃) jedoch noch negativer als bei einer Pt-Elektrode (-228 mV vs. Ag/AgNO₃).

## Patentansprüche

1. Farbstoffsensibilisierte Solarzelle, umfassend:
- eine Metalloxidelektrode;
- eine Gegenelektrode, welche der Metalloxidelektrode zugewandt ist; und
- einen zwischen der Metalloxidelektrode und der Gegenelektrode angeordneten Elektrolyten; wobei die Metalloxidelektrode einen hierauf befindlichen Farbstoff umfasst und der Elektrolyt ein elektrochemisches Redoxpaar umfasst,
**dadurch gekennzeichnet, dass**
zwischen der Metalloxidelektrode und der Gegenelektrode stickstoffdotierte Kohlenstoffnanoröhren angeordnet sind, welche mit der Gegenelektrode elektrisch kontaktiert sind.

2. Solarzelle gemäß Anspruch 1, wobei das elektrochemische Redoxpaar eine anorganische Iodverbindung umfasst.

3. Solarzelle gemäß Anspruch 2, wobei das elektrochemische Redoxpaar das Redoxpaar I⁻/I₃⁻ ist.

4. Solarzelle gemäß Anspruch einem der Ansprüche 1 bis 3, wobei die Gegenelektrode frei von Metallen aus der Gruppe Cobalt, Rhodium, Iridium, Nickel, Palladium, Platin, Kupfer, Silber und Gold ist.

5. Solarzelle gemäß einem der Ansprüche 1 bis 4, wobei die stickstoffdotierten Kohlenstoffnanoröhren mit der Gegenelektrode verbunden sind.

6. Solarzelle gemäß einem der Ansprüche 1 bis 5, wobei die stickstoffdotierten Kohlenstoffnanoröhren einen Stickstoffgehalt von ≥ 0,1 Atom-% bis ≤ 10 Atom-% aufweisen.

7. Solarzelle gemäß einem der Ansprüche 1 bis 6, wobei die stickstoffdotierten Kohlenstoffnanoröhren pyridinische, pyrrolische und/oder quaternäre Stickstoffgruppen mindestens an ihrer Oberfläche umfassen.

8. Solarzelle gemäß einem der Ansprüche 1 bis 7, wobei die stickstoffdotierten Kohlenstoffnanoröhren durch ein Verfahren erhältlich sind, welches die folgenden Schritte umfasst:
- Fällen zweier Metallsalze (MS) der Metalle (M) Cobalt und Mangan, zusammen mit weiteren Komponenten (I) umfassend Magnesium und Aluminium in einem Lösungsmittel (L) unter Erhalt einer Suspension (S) umfassend einen Feststoff (F);
- Abtrennen und gegebenenfalls Nachbehandeln des Feststoffs (F) aus der Suspension (S) unter Erhalt eines heterogenen Metallkatalysators (K) der Form M¹:M²:I¹O:I²O, in dem
M¹ Mangan ist und in einem Massenanteil von ≥ 2% bis ≤ 65% vorliegt,
M² Cobalt ist und in einem Massenanteil von ≥ 2% bis ≤ 80% vorliegt,
I¹O Al₂O₃ ist und in einem Massenanteil von ≥ 5% bis ≤ 76% vorliegt und
I²O MgO ist und in einem Massenanteil von ≥ 5% bis ≤ 70% vorliegt,
wobei sich die genannten Massenanteile zu ≤ 100% addieren;
- Einleiten des heterogenen Metallkatalysators (K) in eine Wirbelschicht;
- Reaktion mindestens eines gasförmigen Eduktes (E), das eine stickstoffhaltige organische Verbindung umfasst, in der Wirbelschicht an dem heterogenen Metallkatalysator (K) bei Temperaturen zwischen 300 °C und 1600 °C unter Erhalt von stickstoffdotierten Kohlenstoffnanoröhren;
- Austragen der stickstoffdotierten Kohlenstoffnanoröhren aus der Wirbelschicht.

9. Solarzelle gemäß einem der Ansprüche 1 bis 7, wobei die stickstoffdotierten Kohlenstoffnanoröhren durch ein Verfahren erhältlich sind, welches das Mahlen von Kohlenstoffnanoröhren unter Ammoniak-, Amin- und/oder Stickstoffatmosphäre umfasst.

10. Solarzelle gemäß einem der Ansprüche 1 bis 9, wobei der Farbstoff ausgewählt ist aus der Gruppe umfassend Xanthenfarbstoffe wie Eosin-Y, Cumarinfarbstoffe, Triphenylmethanfarbstoffe, Cyananinfarbstoffe, Merocyaninfarbstoffe, Phthalocyaninfarbstoffe, Naphthalocyaninfarbstoffe, Porphyrinfarbstoffe, Polypyridin-Metallkomplexfarbstoffe, Ruthenium-Bipyridinfarbstoffe, Azofarbstoffe, Chinonfarbstoffe, Chinoniminfarbstoffe, Chinacridonfarbstoffe, Squariumfarbstoffe, Perylenfarbstoffe, Indigofarbstoffe, Polymethinfarbstoffe und/oder Riboflavinfarbstoffe.

11. Verfahren zur Gewinnung von elektrischer Energie mittels farbstoffsensibilisierter Solarzellen, **dadurch gekennzeichnet, dass** die Solarzelle eine Solarzelle gemäß einem der Ansprüche 1 bis 10 ist.

12. Verwendung von stickstoffdotierten Kohlenstoffnanoröhren als Katalysator in der Reaktion eines elektrochemischen Redoxpaares, **dadurch gekennzeichnet, dass** das elektrochemische Redoxpaar eine anorganische Iodverbindung umfasst.

13. Verwendung gemäß Anspruch 12, wobei das elektrochemische Redoxpaar das Redoxpaar I⁻/I₃⁻ ist.
